# EUROPÄISCHE PATENTANMELDUNG

(11) **EP 3 964 893 A1**
(43) Veröffentlichungstag der Anmeldung: **09.03.2022**
(21) Anmeldenummer: 21174903.1
(22) Anmeldetag: 20.05.2021
(51) Int. Cl.: G03F 7/20, G02B 7/00, G02B 7/182

(54) **KOMPENSATION VON KRIECHEFFEKTEN IN EINER ABBILDUNGSEINRICHTUNG**

(30) Priorität: 29.06.2020 DE 102020208011
(71) Anmelder: Carl Zeiss SMT GmbH, 73447 Oberkochen (DE)
(72) Erfinder: Bektas Knauf, Eylem, 73432 Aalen (DE); Schönhoff, Ulrich, 89073 Ulm (DE); Nefzi, Marwene, 89073 Ulm (DE); Zweering, Ralf, 73431 Aalen (DE); Steimer, Konrad Carl, 68199 Mannheim (DE); Kwan, Yim-Bun Patrick, 73447 Oberkochen (DE)
(74) Vertreter: Carl Zeiss SMT GmbH

(57) **Zusammenfassung**

Die vorliegende Erfindung betrifft eine Anordnung einer optischen Abbildungseinrichtung für die Mikrolithographie, insbesondere für die Verwendung von Licht im extremen UV-Bereich (EUV), mit einer ersten Stützstruktur (111.1) und einer zweiten Stützstruktur (111.2), wobei die erste Stützstruktur (111.1) dazu ausgebildet ist, wenigstens ein optisches Element (107.2) der Abbildungseinrichtung abzustützen. Die erste Stützstruktur (111.1) stützt die zweite Stützstruktur (111.2) über eine Mehrzahl von Stützfedereinrichtungen (113.1) einer Schwingungsentkopplungseinrichtung (113) ab, wobei die Stützfedereinrichtungen (113.1) kinematisch parallel zueinander zwischen der ersten Stützstruktur (111.1) und der zweiten Stützstruktur (111.2) wirken. Jede der Stützfedereinrichtungen (113.1) definiert eine Stützkraftrichtung sowie eine Stützlänge entlang der Stützkraftrichtung. Die zweite Stützstruktur (111.2) stützt eine Messeinrichtung (109.1) ab, die zum Messen der Position und/oder Orientierung des wenigstens einen optischen Elements (107.2) bezüglich einer Referenz (112) in wenigstens einem Freiheitsgrad bis hin zu allen sechs Freiheitsgraden im Raum ausgebildet ist. Weiterhin ist eine Kriechkompensationseinrichtung (115) zur Kompensation einer Änderung einer statischen Relativlage zwischen der ersten Stützstruktur (111.1) und der zweiten Stützstruktur (111.2) in wenigstens einem Korrekturfreiheitsgrad vorgesehen, wobei die Relativlageänderung insbesondere durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt. Die Kriechkompensationseinrichtung (115) umfasst eine ansteuerbare aktive Stelleinrichtung (115.1) mit wenigstens einem aktiven Stellelement (115.2), die dazu ausgebildet ist, eine Länge der Stützfedereinrichtung (113.1) entlang der Stützkraftrichtung der Stützfedereinrichtung (113.1) zu verändern und/oder einen Abstand der Schnittstellen (111.3; 111.4) der Stützfedereinrichtung (113.1) zu der ersten Stützstruktur (111.1) und der zweiten Stützstruktur (111.2) entlang der Stützkraftrichtung der Stützfedereinrichtung (113.1) zu verändern.

## Beschreibung

### HINTERGRUND DER ERFINDUNG

Die vorliegende Erfindung betrifft eine optische Anordnung für die Mikrolithographie, die für die Verwendung von UV Nutzlicht geeignet ist, insbesondere von Licht im extremen ultravioletten (EUV) Bereich. Weiterhin betrifft die Erfindung eine optische Abbildungseinrichtung mit einer solchen Anordnung. Die Erfindung lässt sich im Zusammenhang mit beliebigen optischen Abbildungsverfahren einsetzen. Besonders vorteilhaft lässt sie sich bei der Herstellung oder der Inspektion mikroelektronischer Schaltkreise sowie der hierfür verwendeten optischen Komponenten (beispielsweise optischer Masken) einsetzen.

Die im Zusammenhang mit der Herstellung mikroelektronischer Schaltkreise verwendeten optischen Einrichtungen umfassen typischerweise eine Mehrzahl optischer Elementeinheiten, die ein oder mehrere optische Elemente wie Linsen, Spiegel oder optische Gitter umfassen, die im Abbildungslichtpfad angeordnet sind. Diese optischen Elemente wirken typischerweise in einem Abbildungsprozess zusammen, um ein Bild eines Objekts (beispielsweise ein auf einer Maske gebildetes Muster) auf ein Substrat (beispielsweise einen so genannten Wafer) zu transferieren. Die optischen Elemente sind typischerweise in einer oder mehreren funktionalen Gruppen zusammengefasst, die gegebenenfalls in separaten Abbildungseinheiten gehalten sind. Insbesondere bei hauptsächlich refraktiven Systemen, die mit einer Wellenlänge im so genannten Vakuum-Ultraviolett-Bereich (VUV, beispielsweise bei einer Wellenlänge von 193 nm) arbeiten, sind solche Abbildungseinheiten häufig aus einem Stapel optischer Module gebildet, die ein oder mehrere optische Elemente halten. Diese optischen Module umfassen typischerweise eine Stützstruktur mit einer im Wesentlichen ringförmigen äußeren Stützeinheit, die einen oder mehrere optische Elementhalter abstützt, die ihrerseits das optische Element halten.

Die immer weiter voranschreitende Miniaturisierung von Halbleiterbauelementen führt zu einem ständigen Bedarf an erhöhter Auflösung der für ihre Herstellung verwendeten optischen Systeme. Dieser Bedarf an erhöhter Auflösung bedingt den Bedarf an einer erhöhten numerischen Apertur (NA) und einer erhöhten Abbildungsgenauigkeit der optischen Systeme.

Ein Ansatz, um eine erhöhte optische Auflösung zu erhalten, besteht darin, die Wellenlänge des in dem Abbildungsprozess verwendeten Lichtes zu verringern. In den vergangenen Jahren wurde verstärkt die Entwicklung von Systemen vorangetrieben, bei denen Licht im so genannten extremen Ultraviolettbereich (EUV) verwendet wird, typischerweise bei Wellenlängen von 5 nm bis 20 nm, in den meisten Fällen bei einer Wellenlänge von etwa 13 nm. In diesem EUV-Bereich ist es nicht mehr möglich, herkömmliche refraktive optische Systeme zu verwenden. Dies ist dadurch bedingt, dass die für refraktive optische Systeme verwendeten Materialien in diesem EUV-Bereich einen Absorptionsgrad aufweisen, der zu hoch ist um mit der verfügbaren Lichtleistung akzeptable Abbildungsergebnisse zu erzielen. Folglich müssen in diesem EUV-Bereich reflektive optische Systeme für die Abbildung verwendet werden.

Dieser Übergang zu rein reflektiven optischen Systemen mit hoher numerischer Apertur (z. B. NA > 0,4) im EUV-Bereich führt zu erheblichen Herausforderungen im Hinblick auf das Design der Abbildungseinrichtung.

Die oben genannten Faktoren führen zu sehr strengen Anforderungen hinsichtlich der Position und/oder Orientierung der optischen Elemente, die an der Abbildung teilnehmen, relativ zueinander sowie hinsichtlich der Deformation der einzelnen optischen Elemente, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die Komponenten der optischen Abbildungseinrichtung (also beispielsweise die optischen Elemente der Beleuchtungseinrichtung, die Maske, die optischen Elemente der Projektionseinrichtung und das Substrat), die bei der Abbildung zusammenwirken, in einer wohldefinierten Weise abgestützt werden, um eine vorgegebene wohldefinierte räumliche Beziehung zwischen diesen Komponenten einzuhalten und eine minimale unerwünschte Deformation dieser Komponenten zu erzielen, um letztlich eine möglichst hohe Abbildungsqualität zu erreichen.

Eine Herausforderung besteht hierbei häufig darin, eine möglichst präzise Messung der Lage (also der Position und/oder Orientierung) der an der Abbildung beteiligten optischen Komponenten (beispielsweise der optischen Elemente) vorzunehmen und die Lage zumindest einzelner dieser optischen Elemente dann über eine entsprechend angesteuerte Lageregeleinrichtung aktiv mit der für den Abbildungsprozess erforderlichen Präzision (typischerweise im Bereich von 1 nm und darunter) und Regelbandbreite (typischerweise bis zu 200 Hz) einzustellen. Ein wesentlicher Faktor für die Präzision der Messung ist dabei die stabile und präzise Abstützung der Messeinrichtung, die für die Messung verwendet wird. Diese Abstützung sollte dabei nach Möglichkeit sicherstellen, dass die Komponenten der Messeinrichtung eine wohldefinierte Lage (d. h. Position und/oder Orientierung) bezüglich einer definierten Referenz aufweisen, auf die das Messergebnis der Messeinrichtung bezogen wird.

Eine in diesem Zusammenhang häufig verwendete Möglichkeit, ist die Abstützung der Messeinrichtung auf einer separaten Stützstruktur, die häufig auch als Sensor-Rahmen (englisch: "sensor frame") oder Metrologie-Rahmen (englisch: "metrology frame") bezeichnet wird. Ein solcher Sensor-Rahmen wird dabei typischerweise auf einer weiteren (ein- oder mehrteiligen) lasttragenden Struktur (englisch: "force frame") abgestützt, die neben dem Sensor-Rahmen über die Lageregeleinrichtung auch zumindest einen Teil der optischen Komponenten (z. B. zumindest einen Teil der optischen Elemente) der Abbildungseinrichtung abstützt. Hierdurch kann sichergestellt werden, dass der Sensor-Rahmen weit gehend von den Stützlasten für die optischen Komponenten frei gehalten werden kann.

Um den Sensor-Rahmen hierbei möglichst weitgehend frei von inneren Störungen der Abbildungseinrichtung (z. B. durch bewegte Komponenten induzierte Vibrationen) und äußeren Störungen (z. B. unerwünschte Erschütterungen) zu halten, ist der Sensor-Rahmen häufig über eine Schwingungsentkopplungseinrichtung schwingungsisoliert bzw. schwingungsentkoppelt auf der lasttragenden Struktur abgestützt. Dies geschieht typischerweise über eine Mehrzahl von Stützfedereinrichtungen der Schwingungsentkopplungseinrichtung.

Während hiermit (auf kurzen Zeitskalen) eine gute dynamische Schwingungsisolierung des Sensor-Rahmens erreicht werden kann, hat es sich jedoch gezeigt, dass es auf langen Zeitskalen im Bereich der Schwingungsentkopplungseinrichtung, insbesondere im Bereich der Stützfedereinrichtungen, zu so genannten Kriecheffekten bzw. Setzeffekten kommen kann. Hierdurch ändert sich langfristig die Lage des Sensor-Rahmens und damit die Lage der für die Ansteuerung der Lageregeleinrichtung verwendeten Referenz bezüglich der lasttragenden Struktur. Eine solche Lageänderung der Referenz wird im Betrieb typischerweise durch die Lageregeleinrichtung kompensiert, die hierzu allerdings ausreichende Verfahrwege, mithin also eine ausreichende Bewegungsreserve zur Verfügung stellen muss und demgemäß entsprechend aufwändig bzw. teuer gestaltet sein muss.

### KURZE ZUSAMMENFASSUNG DER ERFINDUNG

Der Erfindung liegt daher die Aufgabe zugrunde, eine optische Anordnung für die Mikrolithographie und eine entsprechende optische Abbildungseinrichtung mit einer solchen Anordnung sowie ein entsprechendes Verfahren zur Verfügung zu stellen, welche bzw. welches die zuvor genannten Nachteile nicht oder zumindest in geringerem Maße aufweist und insbesondere auf möglichst einfache und kostengünstige Weise eine optische Abbildung möglichst hoher Abbildungsqualität ermöglicht.

Die Erfindung löst diese Aufgabe mit den Merkmalen der unabhängigen Ansprüche.

Der Erfindung liegt die technische Lehre zugrunde, dass man auf einfache und kostengünstige Weise eine optische Abbildung hoher Abbildungsqualität erzielen kann, wenn zur Kompensation einer Änderung einer statischen Relativlage zwischen der ersten Stützstruktur und der zweiten Stützstruktur in wenigstens einem Korrekturfreiheitsgrad eine aktiv eine Länge der Stützfedereinrichtung entlang der Stützkraftrichtung der Stützfedereinrichtung verändert wird oder aktiv ein Abstand der Schnittstellen der Stützfedereinrichtung zu der ersten Stützstruktur und der zweiten Stützstruktur entlang der Stützkraftrichtung der Stützfedereinrichtung verändert wird.

Der Begriff "statische Relativlageänderung" soll dabei im Sinne der vorliegenden Erfindung so verstanden werden, dass es sich um die Änderung der Relativlage bzw. eine Drift zwischen der ersten Stützstruktur und der zweiten Stützstruktur handelt, die im rein statischen Zustand, d. h. ohne dynamische Anregung der Strukturen vorliegt. Wie nachfolgend noch näher erläutert wird, kann eine solche statische Relativlageänderung bzw. Drift über geeignete Verfahren erfasst werden, welche kurzfristige bzw. dynamische Einflüsse herausfiltern. So kann beispielsweise eine einfache Mittelung der Relativlageinformation über geeignet lange Zeiträume erfolgen.

Bei herkömmlichen Gestaltungen kann es je nach Ausmaß der statischen Relativlageänderung zu einer vergleichsweise starken statischen (bzw. nicht-dynamischen) Auslenkung der Lageregeleinrichtung und damit der optischen Elemente aus ihrer ursprünglichen Ausgangslage kommen, mit der diese Relativlageänderung kompensiert wird, mithin also die optischen Elemente dieser Relativlageänderung folgen. Dies kann so weit führen, dass die Lageregeleinrichtung nicht mehr in der Lage ist, den für die dynamische Lageregelung der optischen Elemente im Betrieb erforderlichen Verfahrweg aufzubringen, da sie insoweit an ihre Grenzen stößt.

Dieser Konflikt kann bei herkömmlichen Gestaltungen nur gelöst werden, indem die Lageregeleinrichtung mit einem entsprechend großen Bewegungsspielraum ausgeführt wird, der es erlaubt, über die Lebensdauer der Abbildungseinrichtung entsprechend zu reagieren. Dies ist allerdings mit vergleichsweise hohen Kosten verbunden, da gerade eine Verfahrbewegung mit entsprechend hoher Dynamik nur mit vergleichsweise hohem Aufwand zu realisieren ist. Der Teil des dynamischen Bewegungsspielraumes der Lageregeleinrichtung, mit dem die optischen Elemente der statischen Relativlageänderung nachgeführt werden, ist damit letztlich unter Kostengesichtspunkten verschwendet.

Mit der vorliegenden Korrektur bzw. Kompensation ist es demgegenüber in einfacher und vorteilhafter Weise möglich, die zweite Stützstruktur und damit die Referenz nach einer bestimmten längeren Betriebszeit, über die sich Kriech- oder Setzeffekte in der Abstützung der zweiten Stützstruktur spürbar ausgewirkt haben, wieder in ihren Ausgangszustand (oder in dessen Nähe) zurückzusetzen, den sie nach einer initialen Justage der Abbildungseinrichtung (typischerweise unmittelbar bei erstmaliger Inbetriebnahme der Abbildungseinrichtung) innehatte. Dies hat zur Folge, dass dann auch die der Referenz folgende Lageregeleinrichtung bzw. die von der Lageregeleinrichtung getragenen optischen Elemente wieder in ihren Ausgangszustand zurückgeholt werden. Eine Drift in der Lageregeleinrichtung wird somit zumindest im Wesentlichen beseitigt.

Hiermit ist es insbesondere in einfacher und vorteilhafter Weise möglich, den maximal erforderlichen bzw. möglichen Verfahrweg der Lageregeleinrichtung vergleichsweise gering zu halten bzw. auf das Nötigste zu beschränken. Insbesondere ist keine große Bewegungsreserve für die Kompensation langfristiger Kriech- oder Setzeffekte vorzuhalten. Diese Bewegungsreserve kann deutlich kleiner gehalten werden.

Nach einem Aspekt betrifft die Erfindung daher eine Anordnung einer optischen Abbildungseinrichtung für die Mikrolithographie, insbesondere für die Verwendung von Licht im extremen UV-Bereich (EUV), mit einer ersten Stützstruktur und einer zweiten Stützstruktur, wobei die erste Stützstruktur dazu ausgebildet ist, wenigstens ein optisches Element der Abbildungseinrichtung abzustützen. Die erste Stützstruktur stützt die zweite Stützstruktur über eine Mehrzahl von Stützfedereinrichtungen einer Schwingungsentkopplungseinrichtung ab, wobei die Stützfedereinrichtungen kinematisch parallel zueinander zwischen der ersten Stützstruktur und der zweiten Stützstruktur wirken. Jede der Stützfedereinrichtungen definiert eine Stützkraftrichtung, in der sie eine Stützkraft zwischen der ersten Stützstruktur und der zweiten Stützstruktur ausübt, sowie eine Stützlänge entlang der Stützkraftrichtung. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Weiterhin ist eine Kriechkompensationseinrichtung zur Kompensation einer Änderung einer statischen Relativlage zwischen der ersten Stützstruktur und der zweiten Stützstruktur in wenigstens einem Korrekturfreiheitsgrad vorgesehen ist, wobei die Relativlageänderung insbesondere durch eine Längenänderung wenigstens einer der Stützfedereinrichtungen entlang ihrer Stützkraftrichtung bedingt ist, die sich aus einem Kriechprozess der Stützfedereinrichtung ergibt. Die Kriechkompensationseinrichtung umfasst eine ansteuerbare aktive Stelleinrichtung mit wenigstens einem aktiven Stellelement, die dazu ausgebildet ist, eine Länge der Stützfedereinrichtung entlang der Stützkraftrichtung der Stützfedereinrichtung zu verändern. Zusätzlich oder alternativ ist die aktive Stelleinrichtung dazu ausgebildet, einen Abstand der Schnittstellen der Stützfedereinrichtung zu der ersten Stützstruktur und der zweiten Stützstruktur entlang der Stützkraftrichtung der Stützfedereinrichtung zu verändern.

Die Stelleinrichtung kann grundsätzlich auf beliebige geeignete Weise gestaltet sein, um die gewünschte Längenkompensation bzw. Abstandskompensation zu erzielen. Bei bestimmten Varianten umfasst die aktive Stelleinrichtung als aktives Stellelement einen Kraftaktuator. Mit einem solchen Kraftaktuator kann insbesondere eine günstige Abstimmung der Stelleinrichtung auf das Schwingungsisolationsverhalten der Stützfedereinrichtungen erzielt werden.

Zusätzlich oder alternativ kann die aktive Stelleinrichtung als aktives Stellelement einen Lorentz-Aktuator umfassen. Hiermit kann insbesondere eine günstige Abstimmung des der Stelleinrichtung auf das Schwingungsisolationsverhalten der Stützfedereinrichtungen erzielt werden. Zusätzlich oder alternativ kann die aktive Stelleinrichtung als aktives Stellelement einen pneumatischen Aktuator, insbesondere einen pneumatischen Balgaktuator, umfassen. Mit allen diesen Varianten lassen sich jeweils alleine oder in beliebiger, an den jeweiligen Anwendungsfall angepasster Kombination besonders einfache Konfigurationen erzielen.

Zusätzlich oder alternativ kann die aktive Stelleinrichtung als aktives Stellelement einen Wegaktuator umfassen. Dies kann den Vorteil haben, dass der Einfluss auf das Schwingungsisolationsverhalten der Stützfedereinrichtungen gering gehalten werden kann, mithin also im Wesentlichen unverändert bleiben kann. Insbesondere kann die aktive Stelleinrichtung als aktives Stellelement ein piezoelektrisches Stellelement umfassen, womit besonders einfache und robuste Konfigurationen erzielt werden können. Insbesondere kann die aktive Stelleinrichtung einen piezoelektrischen Schrittantrieb (so genannter "Piezokrabbler") umfassen. Ebenso kann es sich bei dem Wegaktuator um einen elektrostriktiven Aktuator handeln.

Bei bestimmten Varianten kann die aktive Stelleinrichtung als aktives Stellelement einen hydraulischen Aktuator, insbesondere einen hydraulischen Balgaktuator, umfassen, der bei entsprechender Inkompressibilität des verwendeten Arbeitsmediums letztlich als Wegaktuator wirken kann. Das Halten des Stellelements in einem einmal eingestellten Stellzustand kann dann einfach durch ein entsprechendes Sperrelement (beispielsweise ein Sperrventil oder dergleichen) in der bzw. den an den hydraulischen Aktuator angeschlossenen Leitungen für das Arbeitsmedium erfolgen. Dabei können insbesondere einfache Rückschlagventile zum Einsatz kommen, wenn Stellbewegungen nur in einer Richtung zu erwarten bzw. erforderlich sind.

Bei bestimmten Varianten umfasst die aktive Stelleinrichtung als aktives Stellelement ein aktives piezoelektrisches Stellelement, wobei das wenigstens eine piezoelektrische Stellelement bei Anlegen einer elektrischen Spannung eine Stellbewegung in einer Stellrichtung durch eine ferroelektrische Domänenumschaltung erzeugt. Dabei ist bevorzugt vorgesehen, dass das wenigstens eine piezoelektrische Stellelement vor dem Anlegen der elektrischen Spannung in der Stellrichtung eine erste Ausdehnung aufweist. Bei Anlegen der elektrischen Spannung wird das wenigstens eine piezoelektrische Stellelement dann in einen Stellzustand mit einer zweiten Ausdehnung in der Stellrichtung verbracht, wobei die erste Ausdehnung von der zweiten Ausdehnung verschieden ist. Nach Entfernen der elektrischen Spannung befindet sich das wenigstens eine piezoelektrische Stellelement dann in einem Haltezustand, in dem es die zweite Ausdehnung spannungslos beibehält. Dies hat den großen Vorteil, dass das Stellelement nur kurz mit der entsprechenden Steuerenergie versorgt werden muss, über die restliche Zeit aber dann ohne Energieversorgung seinen neuen Zustand beibehält.

Bei weiteren Varianten kann vorgesehen sein, dass das wenigstens eine aktive Stellelement vor dem Ansteuern der aktiven Stelleinrichtung in der Stellrichtung eine erste Ausdehnung aufweist, das wenigstens eine Stellelement durch das Ansteuern der aktiven Stelleinrichtung in einen Stellzustand mit einer zweiten Ausdehnung in der Stellrichtung verbracht wird, wobei die erste Ausdehnung von der zweiten Ausdehnung verschieden ist. Hier kann dann eine Halteeinrichtung, insbesondere eine Klemmeinrichtung, vorgesehen sein, die insbesondere schaltbar ausgebildet ist, wobei die Halteeinrichtung dazu ausgebildet ist, das wenigstens eine aktive Stellelement nach Entfernen der Ansteuerung der aktiven Stelleinrichtung in einem Haltezustand zu halten, in dem das aktive Stellelement die zweite Ausdehnung ohne Ansteuerung beibehält. Hiermit ist es also in einfacher Weise möglich, einen Stellzustand, in dem die Relativlageänderung zumindest teilweise kompensiert wurde (mithin also einen Kompensationszustand), zu fixieren. Dies kann in vorteilhafter Weise gegebenenfalls so geschehen, dass in dem Haltezustand dann keine weitere Energiezufuhr erforderlich ist.

Bevorzugt ist die Halteeinrichtung in der Stellrichtung selbsthemmend ausgebildet. Diese Selbsthemmung kann auf beliebige geeignete Weise erzielt werden. Bevorzugt umfasst die Halteeinrichtung wenigstens zwei Keilelemente, die derart angeordnet und ausgebildet sind, dass die zwei Keilelemente bei der Ansteuerung der aktiven Stelleinrichtung durch wenigstens eine Stelleinheit des wenigstens einen aktiven Stellelements gegeneinander in einer Verschieberichtung quer zu der Stellrichtung verschoben werden. Dabei können die zwei Keilelemente insbesondere bei der Verschiebung aufeinander gleiten und dabei eine Stellbewegung in der Stellrichtung erzeugen. Hiermit lassen sich besonders einfache und robuste Konfigurationen erzielen.

Bei bestimmten Varianten ist das wenigstens eine aktive Stellelement eine Komponente der wenigstens einen Stützfedereinrichtung, das an beliebiger geeigneter Stelle innerhalb der Stützfedereinrichtung angeordnet sein kann. Besonders vorteilhaft kann es sein, wenn das wenigstens eine aktive Stellelement insbesondere Teil einer Kopplungseinheit zweier mechanischer Federeinheiten der wenigstens einen Stützfedereinrichtung ist.

Bei weiteren Varianten kann das wenigstens eine aktive Stellelement dazu ausgebildet sein, eine erste Schnittstelleneinheit der ersten Stützstruktur für die wenigstens eine Stützfedereinrichtung entlang der Stützkraftrichtung zu verstellen. Zusätzlich oder alternativ kann das wenigstens eine aktive Stellelement dazu ausgebildet sein, eine zweite Schnittstelleneinheit der zweiten Stützstruktur für die wenigstens eine Stützfedereinrichtung entlang der Stützkraftrichtung zu verstellen.

Bei bevorzugten Varianten ist eine Steuereinrichtung vorgesehen, die dazu ausgebildet ist, in einem Kriechkompensationsmodus in Abhängigkeit von der Längenänderung der wenigstens einen Stützfedereinrichtung entlang ihrer Stützkraftrichtung die aktive Stelleinrichtung zur Kompensation der Relativlageänderung anzusteuern. Die Längenänderung der wenigstens einen Stützfedereinrichtung kann dabei auf beliebige geeignete Weise ermittelt werden. So können eine oder mehrere beliebige geeignete Erfassungsgrößen über entsprechende Erfassungseinrichtungen erfasst werden, die Rückschlüsse auf die Längenänderung ermöglichen. Ebenso kann die Steuereinrichtung zusätzlich oder alternativ zur Ermittlung der Längenänderung der wenigstens einen Stützfedereinrichtung entlang ihrer Stützkraftrichtung ein das Kriechverhalten der Stützfedereinrichtung beschreibendes Kriechmodell der Stützfedereinrichtung verwenden.

Bei bestimmten Varianten sind eine Erfassungseinrichtung und eine Steuereinrichtung vorgesehen, wobei die Erfassungseinrichtung dazu ausgebildet ist, wenigstens einen für die Relativlage zwischen der ersten Stützstruktur und der zweiten Stützstruktur in wenigstens einem Korrekturfreiheitsgrad repräsentativen Relativlageerfassungswert zu erfassen und an die Steuereinrichtung auszugeben. Die Steuereinrichtung ist dazu ausgebildet, in einem Kriechkompensationsmodus in Abhängigkeit von dem Relativlageerfassungswert, insbesondere in Abhängigkeit von einer zeitlichen Änderung des Relativlageerfassungswerts, die Stelleinrichtung zur Kompensation der Relativlageänderung anzusteuern.

Die Ansteuerung der Stelleinrichtung in einem Kriechkompensationsmodus kann grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung etc.) erfolgen.

Bei bestimmten Varianten ist die Steuereinrichtung dazu ausgebildet, den Kriechkompensationsmodus zu aktivieren, wenn eine die durch eine Relativlageänderungsinformation bzw. einen Relativlageerfassungswert repräsentierte Relativlageänderung einen vorgebbaren Grenzwert überschreitet. Hiermit kann natürlich besonders effizient und bedarfsgerecht auf die Kriech- bzw. Setzeffekte reagiert werden.

Zusätzlich oder alternativ kann die Steuereinrichtung dazu ausgebildet sein, den Kriechkompensationsmodus in Abhängigkeit von vorgebbaren Ereignissen, insbesondere in vorgebbaren zeitlichen Intervallen, zu aktivieren, wobei der Kriechkompensationsmodus insbesondere 1 Stunde bis 10 Jahre, vorzugsweise 24 Stunden bis 3 Jahre, weiter vorzugsweise 1 Monat bis 1 Jahr, nach einem Betriebsbeginn der Abbildungseinrichtung und/oder einer vorhergehenden Antivierung des Kriechkompensationsmodus aktiviert wird.

Die Steuereinrichtung kann grundsätzlich auf beliebige geeignete Weise gestaltet sein, eine dem jeweiligen optischen Abbildungsprozess angepasste Ansteuerung der Stelleinrichtung zu realisieren. Dabei wird bevorzugt eine einfache Steuerung realisiert. Es kann aber auch eine Regelung realisiert sein, bei der insbesondere beliebige geeignete Regelbandbreiten für die Ansteuerung der Stelleinrichtung vorgesehen sein können.

Bei dem Freiheitsgrad bzw. den Freiheitsgraden, in denen eine für den Abbildungsprozess bzw. dessen Abbildungsfehler relevante Relativlageänderung durch Kriech- bzw. Setzeffekte erfolgt, kann es sich um beliebige Freiheitsgrade bis hin zu allen sechs Freiheitsgraden im Raum handeln. Dabei können beliebige geeignete Grenzwerte vorgegeben sein, bei deren Überschreitung die Ansteuerung der Stelleinrichtung erforderlich bzw. vorgenommen wird.

Bei bestimmten Varianten ist der wenigstens eine Freiheitsgrad der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur und der zweiten Stützstruktur von einer vorgebbaren Relativsolllage um 0,1 µrad bis 1000 µrad, vorzugsweise 1 µrad bis 200 µrad, weiter vorzugsweise 10 µrad bis 100 µrad, repräsentativ. Zusätzlich oder alternativ kann der wenigstens eine Freiheitsgrad der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur und der zweiten Stützstruktur von einer vorgebbaren Relativsolllage um 0,1 µm bis 1000 µm, vorzugsweise 1 µm bis 200 µm, weiter vorzugsweise 10 µm bis 100 µm, repräsentativ.

Die vorliegenden Erfindung betrifft weiterhin eine optische Abbildungseinrichtung, insbesondere für die Mikrolithographie, mit einer Beleuchtungseinrichtung (102) mit einer ersten optischen Elementgruppe, einer Objekteinrichtung zur Aufnahme eines Objekts, einer Projektionseinrichtung mit einer zweiten optischen Elementgruppe und einer Bildeinrichtung, wobei die Beleuchtungseinrichtung zur Beleuchtung des Objekts ausgebildet ist und die Projektionseinrichtung zur Projektion einer Abbildung des Objekts auf die Bildeinrichtung ausgebildet ist. Die Beleuchtungseinrichtung und/oder die Projektionseinrichtung umfasst wenigstens eine erfindungsgemäße Anordnung. Hiermit lassen sich die oben beschriebenen Varianten und Vorteile in demselben Maße realisieren, sodass insoweit auf die obigen Ausführungen Bezug genommen wird.

Die vorliegenden Erfindung betrifft weiterhin ein Verfahren für eine optische Abbildungseinrichtung für die Mikrolithographie, insbesondere für die Verwendung von Licht im extremen UV-Bereich (EUV), bei dem eine erste Stützstruktur eine zweite Stützstruktur über eine Mehrzahl von Stützfedereinrichtungen einer Schwingungsentkopplungseinrichtung abstützt und dazu ausgebildet ist, wenigstens ein optisches Element der Abbildungseinrichtung abzustützen. Die Stützfedereinrichtungen wirken kinematisch parallel zueinander zwischen der ersten Stützstruktur und der zweiten Stützstruktur. Jede der Stützfedereinrichtungen definiert eine Stützkraftrichtung, in der sie eine Stützkraft zwischen der ersten Stützstruktur und der zweiten Stützstruktur ausübt, sowie eine Stützlänge entlang der Stützkraftrichtung. Die zweite Stützstruktur stützt eine Messeinrichtung ab, die zum Messen der Position und/oder Orientierung des wenigstens einen optischen Elements bezüglich einer Referenz, insbesondere einer Referenz der zweiten Stützstruktur, in wenigstens einem Freiheitsgrad bis hin zu allen sechs Freiheitsgraden im Raum ausgebildet ist. Es wird eine Änderung einer statischen Relativlage zwischen der ersten Stützstruktur und der zweiten Stützstruktur in wenigstens einem Freiheitsgrad in einem Kompensationsschritt kompensiert, wobei die Relativlageänderung insbesondere durch eine Längenänderung wenigstens einer der Stützfedereinrichtungen entlang ihrer Stützkraftrichtung bedingt ist, die sich aus einem Kriechprozess der Stützfedereinrichtung ergibt. Dabei wird eine Länge der Stützfedereinrichtung entlang der Stützkraftrichtung der Stützfedereinrichtung durch ein aktives Stellelement einer aktiven Stelleinrichtung verändert und/oder eine Abstand der Schnittstellen der Stützfedereinrichtung zu der ersten Stützstruktur und der zweiten Stützstruktur entlang der Stützkraftrichtung der Stützfedereinrichtung durch ein aktives Stellelement einer aktiven Stelleinrichtung verändert. Hiermit lassen sich die oben beschriebenen Varianten und Vorteile ebenfalls in demselben Maße realisieren, sodass insoweit auf die obigen Ausführungen Bezug genommen wird.

Bevorzugt wird in dem Kompensationsschritt wenigstens ein piezoelektrisches Stellelement der aktiven Stelleinrichtung angesteuert wird, wobei insbesondere an das wenigstens eine piezoelektrische Stellelement eine elektrische Spannung angelegt wird und das wenigstens eine piezoelektrische Stellelement bei Anlegen der elektrischen Spannung eine Stellbewegung in einer Stellrichtung durch eine ferroelektrische Domänenumschaltung erzeugt.

Bei weiteren Varianten weist das wenigstens eine piezoelektrische Stellelement vor dem Anlegen der elektrischen Spannung in der Stellrichtung eine erste Ausdehnung auf, wobei das wenigstens eine piezoelektrische Stellelement bei Anlegen der elektrischen Spannung in einen Stellzustand mit einer zweiten Ausdehnung in der Stellrichtung verbracht wird, wobei die erste Ausdehnung von der zweiten Ausdehnung verschieden ist. Dann wird die elektrische Spannung entfernt. Das wenigstens eine piezoelektrische Stellelement befindet sich nach Entfernen der elektrischen Spannung in einem Haltezustand, in dem es die zweite Ausdehnung spannungslos beibehält.

Bei weiteren Varianten weist das wenigstens eine aktive Stellelement vor dem Ansteuern der aktiven Stelleinrichtung in der Stellrichtung eine erste Ausdehnung auf. Das wenigstens eine Stellelement wird dann in dem Kompensationsschritt durch das Ansteuern der aktiven Stelleinrichtung in einen Stellzustand mit einer zweiten Ausdehnung in der Stellrichtung verbracht wird, wobei die erste Ausdehnung von der zweiten Ausdehnung verschieden ist. Das wenigstens eine aktive Stellelement wird dann nach Entfernen der Ansteuerung der aktiven Stelleinrichtung in einem Haltezustand gehalten, insbesondere geklemmt, in dem das aktive Stellelement die zweite Ausdehnung ohne Ansteuerung beibehält.

Weitere Aspekte und Ausführungsbeispiele der Erfindung ergeben sich aus den abhängigen Ansprüchen und der nachfolgenden Beschreibung bevorzugter Ausführungsbeispiele, die sich auf die beigefügten Figuren bezieht. Alle Kombinationen der offenbarten Merkmale, unabhängig davon, ob diese Gegenstand eines Anspruchs sind oder nicht, liegen im Schutzbereich der Erfindung.

### KURZE BESCHREIBUNG DER ZEICHNUNGEN

- Figur 1: ist eine schematische Darstellung einer bevorzugten Ausführung einer erfindungsgemäßen optischen Abbildungseinrichtung, die eine bevorzugte Ausführung einer erfindungsgemäßen optischen Anordnung umfasst.
- Figur 2: ist eine schematische Ansicht eines Teils der Abbildungseinrichtung aus Figur 1 in einem ersten Zustand.
- Figur 3: ist eine schematische Ansicht des Teils der Abbildungseinrichtung aus Figur 2 in einem zweiten Zustand.
- Figur 4: ist eine schematische Ansicht des Teils einer Variante der Abbildungseinrichtung aus Figur 2.
- Figur 5: ist eine schematische Ansicht des Teils einer Variante der Abbildungseinrichtung aus Figur 2.
- Figur 6: ist ein Ablaufdiagramm eines bevorzugten Ausführungsbeispiels eines erfindungsgemäßen Verfahrens, das mit der Abbildungseinrichtung aus Figur 1 durchgeführt werden kann.

### DETAILLIERTE BESCHREIBUNG DER ERFINDUNG

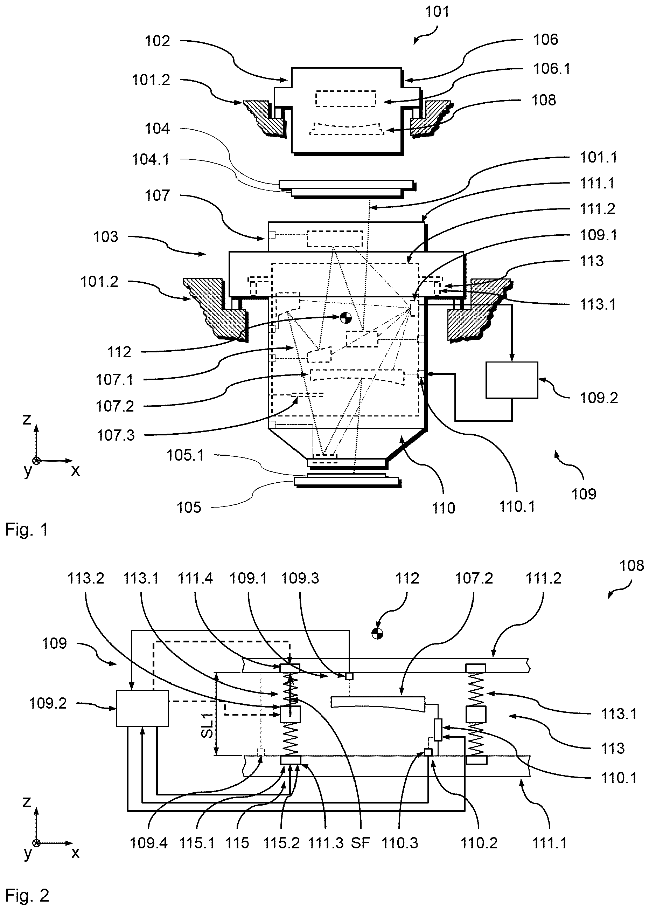

Im Folgenden werden unter Bezugnahme auf die Figuren 1 bis 6 bevorzugte Ausführungsbeispiele einer erfindungsgemäßen optischen Abbildungseinrichtung in Form einer Projektionsbelichtungsanlage 101 für die Mikrolithographie beschrieben, die bevorzugte Ausführungsbeispiele einer erfindungsgemäßen optischen Anordnung umfassen. Zur Vereinfachung der nachfolgenden Ausführungen wird in den Zeichnungen ein x,y,z-Koordinatensystem angegeben, wobei die z-Richtung entgegen der Richtung der Gravitationskraft verläuft. Selbstverständlich ist es in weiteren Ausgestaltungen möglich, beliebige davon abweichende Orientierungen eines x,y,z-Koordinatensystems zu wählen.

Figur 1 ist eine schematische, nicht maßstabsgetreue Darstellung der Projektionsbelichtungsanlage 101, die in einem Mikrolithographieprozess zur Herstellung von Halbleiterbauelementen verwendet wird. Die Projektionsbelichtungsanlage 101 umfasst eine Beleuchtungseinrichtung 102 und eine Projektionseinrichtung 103. Die Projektionseinrichtung 103 ist dazu ausgebildet, in einem Belichtungsprozess ein Bild einer Struktur einer Maske 104.1, die in einer Maskeneinheit 104 angeordnet ist, auf ein Substrat 105.1 zu übertragen, das in einer Substrateinheit 105 angeordnet ist. Dazu beleuchtet die Beleuchtungseinrichtung 102 die Maske 104.1. Die optische Projektionseinrichtung 103 empfängt das Licht von der Maske 104.1 und projiziert das Bild der Maskenstruktur der Maske 104.1 auf das Substrat 105.1, wie z.B. einen Wafer oder dergleichen.

Die Beleuchtungseinrichtung 102 umfasst eine optische Einheit 106 mit einer optischen Elementgruppe 106.1. Die Projektionseinrichtung 103 umfasst eine weitere optische Einheit 107 mit einer optischen Elementgruppe 107.1. Die optischen Elementgruppen 106.1, 107.1 sind entlang eines gefalteten Mittenstrahlverlaufs 101.1 der Projektionsbelichtungsanlage 101 angeordnet. Jede der optischen Elementgruppen 106.1, 107.1 kann eine beliebige Vielzahl optischer Elemente umfassen.

In dem vorliegenden Ausführungsbeispiel arbeitet die Projektionsbelichtungsanlage 101 mit Nutzlicht im EUV-Bereich (extrem ultraviolette Strahlung), mit Wellenlängen zwischen 5 nm bis 20 nm, insbesondere mit einer Wellenlänge von 13 nm. Bei den optischen Elementen der Elementgruppen 106.1, 107.1 der Beleuchtungseinrichtung 102 und der Projektionseinrichtung 103 handelt es sich daher ausschließlich um reflektive optische Elemente. Die optischen Elementgruppen 106.1, 107.1 können ein oder mehrere erfindungsgemäße optischen Anordnungen umfassen, wie dies nachfolgend anhand der optischen Anordnung 108 beschrieben wird. Die optischen Einheiten 106 und 107 sind jeweils über eine Basisstruktur 101.2 abgestützt.

In weiteren Ausgestaltungen der Erfindung ist es (insbesondere in Abhängigkeit von der Wellenlänge des Beleuchtungslichts) selbstverständlich auch möglich, für die optischen Module jede Art von optischen Elementen (refraktiv, reflektiv, diffraktiv) alleine oder in beliebiger Kombination einzusetzen.

Die erfindungsgemäße Anordnung wird im Folgenden beispielhaft anhand der Anordnung 108 beschrieben, die ein Teil der Projektionseinrichtung 103 ist. Bei der Abbildungseinrichtung 101 bestehen unter anderem sehr strenge Anforderungen hinsichtlich der Position und/oder Orientierung der optischen Elemente der optischen Elementgruppe 107.1 der Projektionseinrichtung 103 relativ zueinander, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die optischen Elemente der optischen Elementgruppe 107.1 in einer wohldefinierten Weise abgestützt werden, um eine vorgegebene wohldefinierte räumliche Beziehung zwischen den optischen Elementen der Elementgruppe 107.1 und den übrigen optischen Komponenten einzuhalten und so letztlich eine möglichst hohe Abbildungsqualität zu erreichen.

Hierzu wird im vorliegenden Beispiel eine Messung der Lage (also der Position und/oder Orientierung) der optischen Elemente der Elementgruppe 107.1 mittels einer (in Figur 1 nur sehr vereinfacht dargestellten) Messeinrichtung 109.1 einer Steuereinrichtung 109 vorgenommen. Die Messeinrichtung 109.1 liefert ihre Messsignale LMS an eine Steuereinheit 109.2 der Steuereinrichtung 109. Die Steuereinheit 109.2 steuert dann in Abhängigkeit von den Messsignalen LMS der Messeinrichtung 109.1 eine Lageregeleinrichtung 110 an, die auf einer lasttragenden ersten Struktur 111.1 abgestützt ist. Über die Lageregeleinrichtung 110 wird dann die Lage jedes der optischen Elemente der Elementgruppe 107.1 bezüglich einer zentralen Referenz 112 aktiv mit der für den Abbildungsprozess erforderlichen Präzision (typischerweise im Bereich von 1 nm und darunter) und Regelbandbreite (typischerweise bis zu 200 Hz) eingestellt.

Im vorliegenden Beispiel gibt die Messeinrichtung 109.1 eine Messinformation MI an die Lageregeleinrichtung 110 aus, die für die jeweiligen Position und/oder Orientierung des jeweiligen optischen Elements der Elementgruppe 107.1 bezüglich der Referenz 112 in wenigstens einem Freiheitsgrad im Raum repräsentativ ist. Im Zustand bei der erstmaligen Inbetriebnahme der Abbildungseinrichtung 101 (in dem sich die Abbildungseinrichtung 101 in einem ersten Betriebszustand OM1 befindet) steuert die Steuereinheit 109.2 somit die Lageregeleinrichtung 110 in Abhängigkeit von der Messinformation MI entsprechend an, um einen ersten Sollzustand S1 der Position und/oder Orientierung der optische Elemente der Elementgruppe 107.1 bezüglich der Referenz 112 zu erzeugen, wie es in Figur 2 für ein optisches Element 107.2 der Elementgruppe 107.1 dargestellt ist.

Ein wesentlicher Faktor für die erzielbare Abbildungsqualität der Abbildungseinrichtung 101 ist die Präzision der Messung der Messeinrichtung 109.1, die wiederum von einer möglichst stabilen und präzisen Abstützung der Messeinrichtung 109.1 abhängt. Diese Abstützung sollte dabei nach Möglichkeit sicherstellen, dass die Komponenten der Messeinrichtung 109.1 eine wohldefinierte Lage (d. h. Position und/oder Orientierung) bezüglich der zentralen Referenz 112 aufweisen, auf die das Messergebnis der Messeinrichtung 109.1 bezogen wird.

Hierzu sind die Messeinheiten 109.3 der Messeinrichtung 109.1 auf einer separaten zweiten Stützstruktur 111.2 abgestützt, die häufig auch als Sensor-Rahmen bezeichnet wird. Der Sensor-Rahmen 111.2 ist seinerseits der (ein- oder mehrteiligen) lasttragenden ersten Struktur 111.1 abgestützt. Hierdurch kann sichergestellt werden, dass der Sensor-Rahmen 111.2 weit gehend von den Stützlasten für die optischen Elemente der Elementgruppe 107.1 frei gehalten werden kann.

Um den Sensor-Rahmen 111.2 möglichst weitgehend frei von inneren Störungen der Abbildungseinrichtung 101 (z. B. durch bewegte Komponenten induzierte Vibrationen) und äußeren Störungen (z. B. unerwünschte Erschütterungen) zu halten, ist der Sensor-Rahmen 111.2 über eine Schwingungsentkopplungseinrichtung 113 schwingungsisoliert bzw. schwingungsentkoppelt auf der lasttragenden Struktur 111.1 abgestützt. Dies geschieht über eine Mehrzahl von Stützfedereinrichtungen 113.1 der Schwingungsentkopplungseinrichtung 113, wobei die Stützfedereinrichtungen 113.1 kinematisch parallel zueinander zwischen der lasttragenden ersten Stützstruktur 111.1 und dem Sensor-Rahmen 111.2 wirken. Jede der Stützfedereinrichtungen 113.1 definiert eine Stützkraftrichtung SFR, in der sie eine Stützkraft SF zwischen der ersten Stützstruktur 111.1 und der zweiten Stützstruktur 111.2 ausübt, sowie eine Stützlänge SL1 entlang der Stützkraftrichtung SFR.

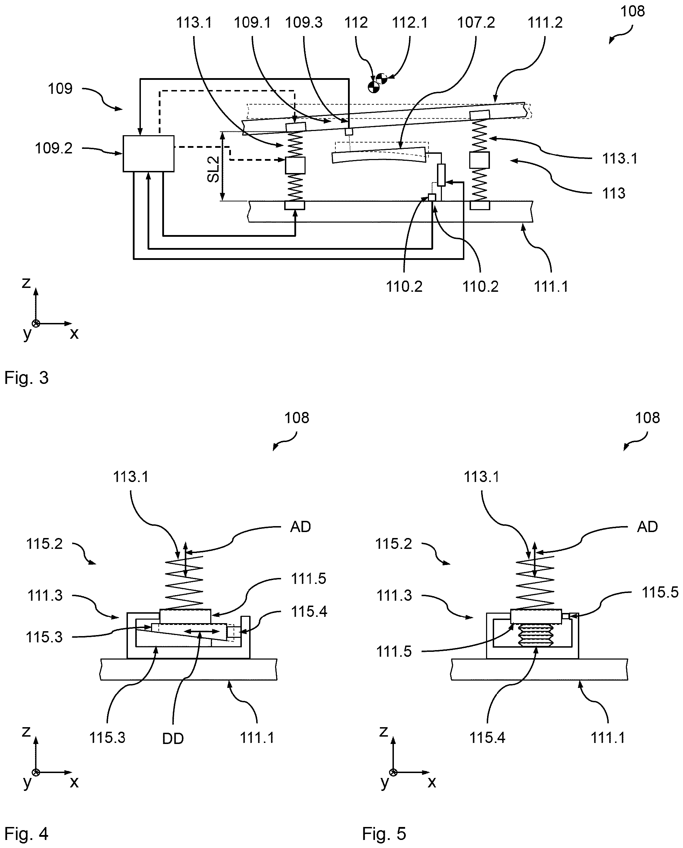

Während hiermit (auf kurzen Zeitskalen) eine gute dynamische Schwingungsisolierung bzw. Schwingungsentkopplung des Sensor-Rahmens 111.2 von der lasttragenden ersten Stützstruktur 111.1 erreicht werden kann, hat es sich jedoch gezeigt, dass es auf langen Zeitskalen im Bereich der Schwingungsentkopplungseinrichtung 113, insbesondere im Bereich der Stützfedereinrichtungen 113.1, zu so genannten Kriecheffekten bzw. Setzeffekten kommen kann. Hierdurch ändert sich langfristig die Stützlänge der Stützfedereinrichtungen 113.1 (wie dies in Figur 3 und 4 durch die Länge SL2 angedeutet ist) und damit sowohl die Lage des Sensor-Rahmens 111.2 als auch die Lage der für die Ansteuerung der Lageregeleinrichtung 110 verwendeten Referenz 112 bezüglich der lasttragenden Struktur 111.1 (gegenüber der in Figur 3 durch die Kontur 112.1 angedeuteten Ausgangslage), wie dies (stark übertrieben) in Figur 3 dargestellt ist. Eine solche Lageänderung der Referenz 112 kann im Normalbetrieb der Abbildungseinrichtung 101 grundsätzlich durch die Lageregeleinrichtung 110 kompensiert werden, indem die optischen Elemente der Elementgruppe 107.1 der Referenz 112 nachgeführt werden (wie dies in Figur 3 dargestellt ist). Eine solche Kompensation der Lageänderung der Referenz 112 durch die Lageregeleinrichtung 110 über die Lebensdauer der Abbildungseinrichtung 101 würde jedoch ausreichende Verfahrwege, mithin also eine ausreichende Bewegungsreserve der Lageregeleinrichtung 110 erfordern, wodurch diese entsprechend aufwändig bzw. teuer gestaltet sein müsste.

Um dies zu vermeiden, ist im vorliegenden Beispiel eine Kriechkompensationseinrichtung 115 zur Kompensation einer solchen Änderung der statischen Relativlage zwischen der ersten Stützstruktur 111.1 und der zweiten Stützstruktur 111.2 in wenigstens einem Korrekturfreiheitsgrad vorgesehen. Die Kriechkompensationseinrichtung 115 umfasst eine durch die Steuereinheit 109.2 ansteuerbare aktive Stelleinrichtung 115.1 mit einem aktiven Stellelement 115.2. Die aktive Stelleinrichtung 115.1 ist dazu ausgebildet, einen Abstand der Schnittstellen 111.3 und 111.4 der jeweiligen Stützfedereinrichtung 113.1 zu der ersten Stützstruktur 111.1 und der zweiten Stützstruktur 111.2 entlang der Stützkraftrichtung SF der Stützfedereinrichtung 113.1 zu verändern, um eine zumindest teilweise Kompensation der Relativlageänderung zu erreichen.

Hierzu ist das aktive Stellelement 115.2 im vorliegenden Beispiel in die Schnittstellen 111.3 der jeweiligen Stützfedereinrichtung 113.1 zu der ersten Stützstruktur 111.1 integriert. Bei anderen Varianten kann ein aktives Stellelement 115.2 zusätzlich oder alternativ auch in die Schnittstellen 111.4 der jeweiligen Stützfedereinrichtung 113.1 zu der zweiten Stützstruktur 111.2 integriert und entsprechend angesteuert sein (wie dies in Figur 2 und 3 durch die gestrichelte Steuerleitung angedeutet ist).

Ebenso kann ein aktives Stellelement 115.2 zusätzlich oder alternativ zu den vorgenannten Varianten in eine Einheit 113.2 der jeweiligen Stützfedereinrichtung 113.1 integriert sein. Die aktive Stelleinrichtung 115.1 ist in diesem Fall dann dazu ausgebildet, gesteuert durch die Steuereinheit 109.2 (wie dies in Figur 2 und 3 durch die gestrichelte Steuerleitung angedeutet ist) eine Länge der Stützfedereinrichtung 113.1 entlang der Stützkraftrichtung SF der Stützfedereinrichtung 113.1 zu verändern und so eine zumindest teilweise Kompensation der Relativlageänderung zu erreichen.

Hierzu erfasst die Steuereinrichtung 109 im vorliegenden Beispiel eine für eine Änderung der statischen Relativlage zwischen der lasttragenden ersten Stützstruktur 110.1 und der zweiten Stützstruktur 110.2 in wenigstens einem Freiheitsgrad repräsentative Relativlageänderungsinformation RSCI. Die Steuereinrichtung 109 weist einen Kriechkompensationsmodus CCM auf, in dem die aktive Stelleinrichtung 115.1 von der Steuereinheit 109.2 angesteuert wird, um Abstand der Schnittstellen 111.3 und 111.4 über das Stellelement 115.2 in Abhängigkeit von der Relativlageänderungsinformation RSCI in zu ändern (typischerweise zu verringern, um eine Verkürzung der Stützfedereinrichtung 113.1 in Folge von Kriech- oder Setzeffekten auszugleichen). Die Stellbewegung des Stellelements 115.2 ist dabei so gewählt, dass der Sensor-Rahmen 111.2 wieder in den in Figur 2 dargestellten Ausgangszustand verbracht wird. Die aktive Stelleinrichtung 115.1 verbleibt dann in einem dem Kriechkompensationsmodus CCM nachfolgenden zweiten Betriebsmodus OM2 in diesem verstellten Zustand.

Es versteht sich, dass für die Ansteuerung der Stelleinrichtung 115.1 sowohl ein geschlossener Regelkreis realisiert sein kann (bei dem die Relativlageänderungsinformation RSCI über entsprechende Erfassungssignale tatsächlich erfasst wird) als auch eine offene Steuerstrecke realisiert sein kann (bei dem die Relativlageänderungsinformation RSCI beispielsweise über ein entsprechendes Modell ermittelt wird), wie dies nachfolgend noch näher erläutert wird.

Mit dieser Korrektur bzw. Kompensation ist es zum Beispiel in einfacher und vorteilhafter Weise möglich, den Sensor-Rahmen 111.2, die Referenz 12 und damit die Lageregeleinrichtung 110 (und die von ihr getragenen optischen Elemente der Elementgruppe 107.1, wie beispielsweise das optische Element 107.2) nach einer bestimmten längeren Betriebszeit (über die sich Kriech- oder Setzeffekte in der Abstützung der zweiten Stützstruktur 110.2 spürbar ausgewirkt haben) wieder in ihren Ausgangszustand (oder in dessen Nähe) zurückzusetzen, den sie nach einer initialen Justage der Abbildungseinrichtung (typischerweise unmittelbar bei erstmaliger Inbetriebnahme der Abbildungseinrichtung 101), mithin also in dem ersten Betriebszustand OM1 innehatte.

Hiermit ist es insbesondere in einfacher und vorteilhafter Weise möglich, den maximal erforderlichen bzw. möglichen Verfahrweg der Lageregeleinrichtung 110 vergleichsweise gering zu halten bzw. auf das Nötigste zu beschränken. Insbesondere ist keine große Bewegungsreserve für die Kompensation langfristiger Kriech- oder Setzeffekte durch die Lageregeleinrichtung 110 vorzuhalten. Diese Bewegungsreserve kann deutlich kleiner gehalten werden und sich beispielsweise auf einen für die Dauer des ersten Betriebsmodus OM1 zu erwartenden Wert beschränken.

Es versteht sich, dass das Ansteuern des Stellelements 115.2 beliebig oft wiederholt werden kann, mithin also beliebig oft in den Kriechkompensationsmodus CCM geschaltet werden kann. Hiermit ist es möglich, über die gesamte Lebensdauer der Abbildungseinrichtung 101 ein entsprechend günstiges Betriebsverhalten zu erzielen.

Die Relativlageänderung bzw. die zugehörige Relativlageänderungsinformation RSCI kann grundsätzlich auf beliebige geeignete Weise ermittelt werden. So kann die Lageregeleinrichtung 110 beispielsweise eine mit der Steuereinheit 109.2 verbundene Auslenkungserfassungseinrichtung 110.2 umfassen. Die Auslenkungserfassungseinrichtung 110.2 erfasst eine Auslenkungsinformation DI, die für eine Auslenkung des optischen Elements 107.2 bezüglich der ersten Stützstruktur 111.1 in wenigstens einem Freiheitsgrad aus dem ersten Ausgangszustand repräsentativ ist. Die Steuereinrichtung 109 leitet aus der Auslenkungsinformation DI, insbesondere in Abhängigkeit von einer zeitlichen Änderung der Auslenkungsinformation DI, dann die Relativlageänderungsinformation RSCI ab.

So kann die Lageregeleinrichtung 110 zur aktiven Verstellung des optischen Elements 107.2 eine Reihe von Lageregelaktuatoren 110.1 umfassen, von denen aus Gründen der Übersichtlichkeit in den Figuren 2 und 3 jeweils nur ein Lageregelaktuator 110.1 dargestellt ist. Bei typischen Varianten sind mehrere Lageregelaktuatoren 110.1 vorgesehen, die nach Art einer Parallelkinematik zwischen der ersten Stützstruktur 111.1 und dem optischen Element 107.1 wirken. Beispielsweise können sechs Lageregelaktuatoren 110.1 vorgesehen sein, die nach Art einer Hexapod-Kinematik wirken.

Eine Auslenkungserfassungseinrichtung 110.2 kann beispielsweise eine Verstellinformation VI erfassen, die für eine Verstellung des jeweiligen Lageregelaktuators 110.1 aus dem justierten ersten Ausgangszustand repräsentativ ist. Die Steuereinrichtung 109.1 kann dann aus der Verstellinformation VI, insbesondere in Abhängigkeit von einer zeitlichen Änderung der Verstellinformation VI, die Relativlageänderungsinformation RSCI ableiten.

Weiterhin kann die Auslenkungserfassungseinrichtung 110.2 wenigstens einen Verstellsensor 110.3 umfassen, der dem jeweiligen Lageregelaktuator 110.1 zugeordnet ist. Der Verstellsensor 110.3 gibt eine für die Stellbewegung des Lageregelaktuators 110.1, insbesondere eine Längenänderung des Lageregelaktuators 110.1, repräsentative Verstellsensorinformation VSI aus. Die Steuereinrichtung 109 kann dann aus der Verstellsensorinformation VSI die Verstellinformation VI ableiten. Dabei versteht es sich, dass grundsätzlich beliebig viele Verstellsensoren 110.3 je Lageregelaktuator 110.1 vorgesehen sein können, um die Verstellinformation VI zu ermitteln. Im vorliegenden Beispiel sind dem jeweiligen Lageregelaktuator 110.1 wenigstens zwei Verstellsensoren 110.3 zugeordnet, da hiermit eine besonders zuverlässige, fehlertolerante Ermittlung der Verstellinformation VI möglich ist.

Es versteht sich jedoch, dass die Verstellinformation VI bei anderen Varianten (zusätzlich oder alternativ zu der Verwendung der Verstellsensoren 110.3) grundsätzlich auch auf beliebige andere geeignete Weise erfasst werden kann. So kann beispielsweise vorgesehen sein, beginnend mit dem ersten Ausgangszustand die Steuersignale für den jeweiligen einen Lageregelaktuator 110.2 lückenlos in einer Historie zu erfassen bzw. nachzuhalten und aus dieser Historie der Steuersignale die Verstellinformation VI zu ermitteln.

Bei bestimmten Varianten kann die Steuereinrichtung 109 gegebenenfalls auch eine (nicht näher dargestellte) Abbildungsfehlererfassungseinrichtung umfassen, die wenigstens eine für einen Abbildungsfehler der Abbildungseinrichtung repräsentative Abbildungsfehlerinformation IEI erzeugt. Die Steuereinrichtung 109 leitet dann aus der Abbildungsfehlerinformation IEI, insbesondere in Abhängigkeit von einer zeitlichen Änderung der Abbildungsfehlerinformation IEI, die Relativlageänderungsinformation RSCI. Diese Varianten nutzen in vorteilhafter Weise einen bekannten Zusammenhang zwischen dem Abbildungsfehler der Abbildungseinrichtung und der durch Kriech- bzw. Setzeffekte bedingten statischen Relativlageänderung zwischen der ersten Stützstruktur 111.1 und der zweiten Stützstruktur 111.2. So können bestimmte Relativlageänderungen charakteristische Abbildungsfehler hervorrufen, mithin also einen charakteristischen Fingerabdruck aufweisen, der zuvor theoretisch und/oder durch simulatorisch ermittelt wurde. Diese charakteristischen Abbildungsfehler bzw. Fingerabdrücke können dann genutzt werden, um im Betrieb in der Steuereinrichtung 109 auf eine tatsächliche Relativlageänderung zu schließen.

Ein besonders deutlicher Zusammenhang zwischen dem Abbildungsfehler und einer solchen Relativlageänderung ergibt sich insbesondere bei Varianten, bei denen die optische Abbildungseinrichtung 101 auch passive optische Komponenten umfasst, die an der Abbildung beteiligt sind, jedoch nicht aktiv über die Lageregeleinrichtung 110 eingestellt werden, sondern im Betrieb im Wesentlichen starr mit der ersten Stützstruktur 111.1 verbunden sind, wie dies in Figur 1 durch die Kontur 107.3 angedeutet ist, die eine Blende repräsentiert. In diesem Fall werden nur die aktiv eingestellten optischen Elemente der Elementgruppe 107.1 durch die Lageregeleinrichtung 110 der Relativlageänderung nachgeführt, während die passiven Komponenten, wie die Blende 107.3, in ihrer Lage verbleiben und sich damit eine Lageänderung zwischen den optischen Komponenten 107.1 und 107.3 ergibt, die einen charakteristischen Abbildungsfehler nach sich zieht.

Bei weiteren Varianten kann die Steuereinrichtung 109 zusätzlich oder alternativ eine Relativlageerfassungseinrichtung umfassen, wie sie in Figur 2 durch die Kontur 109.4 angedeutet ist. Die Relativlageerfassungseinrichtung 109.4 erzeugt dabei wenigstens eine für die Relativlage zwischen der ersten Stützstruktur 111.1 und der zweiten Stützstruktur 111.2 in wenigstens einem Freiheitsgrad repräsentative Relativlageinformation RSI, die an die Steuereinheit 109.2 ausgegeben wird. Die Steuereinrichtung 109 ist leitet dann aus der Relativlageinformation RSI, insbesondere in Abhängigkeit von einer zeitlichen Änderung der Relativlageinformation RSI, die Relativlageänderungsinformation RSCI ab. Hiermit kann eine besonders einfache und präzise Erfassung der Relativlageänderungsinformation RSCI realisiert werden.

Während die vorstehend beschriebenen Varianten jeweils einen geschlossenen Regelkreis realisieren, kann wie erwähnt auch eine Variante mit einer offenen Steuerstrecke realisiert sein. So kann bei bestimmten Varianten die Steuereinrichtung 109 bei bestimmten Varianten zur Ermittlung der Relativlageänderungsinformation RSCI auch ein Kriechmodell CM der Stützfedereinrichtung 113 verwenden, wobei das Kriechmodell CM der Stützfedereinrichtung 113 das Kriechverhalten der Stützfedereinrichtung 113 beschreibt. Aus diesem mit ausreichender Genauigkeit bekannten Kriechverhalten kann die Relativlageänderungsinformation RSCI dann gegebenenfalls ohne weitere Sensorik ermittelt werden und unmittelbar für die Ansteuerung verwendet werden. Bei weiteren Varianten kann das Kriechmodell CM aber auch für eine Plausibilitätsprüfung der Relativlageänderungsinformation RSCI verwendet werden, welche auf eine andere vorstehend oder nachfolgend beschriebene Weise ermittelt wurde.

Es sei an dieser Stelle nochmals erwähnt, dass die vorstehend oder nachfolgend beschriebenen Varianten zur Ermittlung der Relativlageänderungsinformation RSCI grundsätzlich auf beliebige Weise kombiniert werden können, um beispielsweise eine konsolidierte (beispielsweise gemittelte) Relativlageänderungsinformation RSCI zu erlangen. Zusätzlich oder alternativ können natürlich auch einzelne Varianten der Ermittlung der Relativlageänderungsinformation RSCI zur Plausibilitätsprüfung der Ergebnisse der anderen Varianten der Ermittlung der Relativlageänderungsinformation RSCI verwendet werden.

Das Ansteuern des Stellelements 115.2 kann weiterhin grundsätzlich zu beliebigen geeigneten Zeitpunkten bzw. ausgelöst durch beliebige zeitliche Ereignisse (beispielsweise vorgebbare Intervalle) und/oder nicht-zeitliche Ereignisse (beispielsweise erfasste Schocklasten, Erreichen einer bestimmten Anzahl von Abbildungsvorgängen, das Starten oder Herunterfahren der Abbildungseinrichtung 101 etc.) erfolgen.

Im vorliegenden Beispiel aktiviert die Steuereinrichtung 109 den Kriechkompensationsmodus CCM, wenn die durch die Relativlageänderungsinformation RSCI repräsentierte Relativlageänderung einen vorgebbaren Grenzwert LIM überschreitet (d.h. wenn gilt:
RSCI > LIM). Hiermit kann natürlich besonders effizient und bedarfsgerecht auf die Kriech- bzw. Setzeffekte reagiert werden.

Zusätzlich oder alternativ kann die Steuereinrichtung 109 den Kriechkompensationsmodus CCM wie erwähnt in Abhängigkeit von vorgebbaren Ereignissen, insbesondere in vorgebbaren zeitlichen Intervallen, aktivieren, wobei der Kriechkompensationsmodus insbesondere 1 Stunde bis 10 Jahre, vorzugsweise 24 Stunden bis 3 Jahre, weiter vorzugsweise 1 Monat bis 1 Jahr, nach einem Betriebsbeginn der Abbildungseinrichtung 101 und/oder einer vorhergehenden Antivierung des Kriechkompensationsmodus CCM aktiviert wird.

Die Steuereinrichtung 109 kann grundsätzlich auf beliebige geeignete Weise gestaltet sein, eine dem jeweiligen optischen Abbildungsprozess der Abbildungseinrichtung 101 angepasste Ansteuerung der Lageregeleinrichtung 110 zu realisieren. Dabei wird wie erwähnt bevorzugt eine einfache Steuerung realisiert. Es kann aber auch eine Regelung realisiert sein, bei der beliebige geeignete Regelbandbreiten für die Ansteuerung der Lageregeleinrichtung 110 vorgesehen sein können.

Bei dem Freiheitsgrad bzw. den Freiheitsgraden DOF, in denen eine für den Abbildungsprozess bzw. dessen Abbildungsfehler relevante Relativlageänderung durch Kriech- bzw. Setzeffekte erfolgt, kann es sich um beliebige Freiheitsgrade bis hin zu allen sechs Freiheitsgraden im Raum handeln. Dabei können beliebige geeignete Grenzwerte vorgegeben sein, bei deren Überschreitung das Ansteuern des Stellelements 115.2 erforderlich bzw. vorgenommen wird.

Bei bestimmten Varianten ist der wenigstens eine Freiheitsgrad DOF der Relativlageänderung ein Rotationsfreiheitsgrad, insbesondere ein Rotationsfreiheitsgrad um eine quer zu der Gravitationsrichtung verlaufende Kippachse. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 0,1 µrad bis 1000 µrad, vorzugsweise 1 µrad bis 200 µrad, weiter vorzugsweise 10 µrad bis 100 µrad, repräsentativ. Zusätzlich oder alternativ kann der wenigstens eine Freiheitsgrad DOF der Relativlageänderung ein Translationsfreiheitsgrad sein, insbesondere ein Translationsfreiheitsgrad entlang der Gravitationsrichtung. Der vorgebbare Grenzwert ist dann bevorzugt für eine Abweichung der Relativlage zwischen der ersten Stützstruktur 111.1 und der zweiten Stützstruktur 111.2 von einer vorgebbaren Relativsolllage um 0,1 µm bis 1000 µm, vorzugsweise 1 µm bis 200 µm, weiter vorzugsweise 10 µm bis 100 µm, repräsentativ.

Die Stelleinrichtung 115.1 kann grundsätzlich auf beliebige geeignete Weise gestaltet sein, um Kompensationsbewegung zu erzeugen. Dabei kann die Steifigkeit der Stelleinrichtung 115.1 natürlich auf die Steifigkeit der Stützfedereinrichtungen 113.1 abgestimmt sein, um die gewünschte Entkopplungswirkung der Schwingungsentkopplungseinrichtung 113 in den erforderlichen Entkopplungsfreiheitsgraden zu erzielen. Bevorzugt ist die Stelleinrichtung 115.1 so gestaltet, dass sie in diesen Entkopplungsfreiheitsgraden, in denen die Schwingungsentkopplungseinrichtung 113 eine Entkopplung bereitstellen soll, einen möglichst geringen Einfluss auf Steifigkeit der Abstützung der Sensor-Rahmens 111.2 hat.

Im vorliegenden Beispiel wird ein aktives piezoelektrisches Stellelement als aktives Stellelement 115.2 verwendet, wobei das piezoelektrische Stellelement 115.2 bei Anlegen einer elektrischen Spannung U eine Stellbewegung in seiner Stellrichtung durch eine ferroelektrische Domänenumschaltung erzeugt. Dabei weist das piezoelektrische Stellelement 115.2 vor dem Anlegen der elektrischen Spannung (durch die Steuereinheit 109.2) in seiner Stellrichtung zunächst eine erste Ausdehnung DIM1 auf. Bei Anlegen der elektrischen Spannung U wird das piezoelektrische Stellelement 115.2 dann in einen Stellzustand mit einer zweiten Ausdehnung DIM2 in der Stellrichtung verbracht, wobei die erste Ausdehnung DIM1 derart von der zweiten Ausdehnung DIM2 verschieden ist, dass die gewünschte Kompensationsbewegung erzielt wird (wobei DM2 typischerweise größer ist als DIM1, d. h. gilt: DIM1 < DIM2). Nach Entfernen der elektrischen Spannung U befindet sich das piezoelektrische Stellelement 115.2 dann in einem Haltezustand, in dem es die zweite Ausdehnung DIM2 spannungslos beibehält. Dies hat den großen Vorteil, dass das Stellelement 115.2 nur kurz mit der entsprechenden Steuerenergie versorgt werden muss, über die restliche Zeit aber dann ohne Energieversorgung seinen neuen Zustand beibehält.

Es kann gegebenenfalls vorgesehen sein, dass nur einzelnen Stützfedereinrichtungen 113.1 ein Stellelement 115.2 der Stelleinrichtung 115.1 zugeordnet ist. Bevorzugt geschieht dies natürlich in Abstimmung auf ein zu erwartendes Kriech- bzw. Setzverhalten der Stützfedereinrichtungen 113.1. Besonders vorteilhaft ist es, wenn wie im vorliegenden Beispiel jeder der Stützfedereinrichtungen 113.1 ein Stellelement 115.2 zugeordnet ist. Hiermit ist eine besonders einfache Abstimmung mit einfacher bedarfsgerechter Kompensation von Kriech- bzw. Setzeffekten möglich.

Zur Erzeugung der Stellbewegung können bei weiteren Varianten grundsätzlich auch beliebige andere geeignete Stellelemente 115.2 verwendet werden. So kann das aktive Stellelement 115.2 einen Kraftaktuator umfassen, beispielsweis einen Lorentz-Aktuator oder einen pneumatischen Balgaktuator. Zusätzlich oder alternativ das aktive Stellelement 115.2 einen weiteren Wegaktuator umfassen.

Bei der nachfolgend beschriebenen Variante der Figur 4 wird für das Stellelement 115.2 ein Keiltrieb mit einer Halteeinrichtung verwendet, die in der Stellrichtung AD selbsthemmend ausgebildet ist. Der selbsthemmende Antrieb erfolgt über zwei Keilelemente 115.3, die derart angeordnet und ausgebildet sind, dass sie bei der Ansteuerung der Stelleinrichtung 115.1 durch eine Stelleinheit 115.4 des Stellelements 115.2 gegeneinander in einer Verschieberichtung DD quer zu der Stellrichtung AD verschoben werden. Dabei können die zwei Keilelemente 115.3 bei der Verschiebung aufeinander gleiten und dabei eine Stellbewegung für ein Schnittstellenelement 111.5 für die Stützfedereinrichtung 113.1 in der Stellrichtung AD erzeugen (wie dies in Figur 4 durch die gestrichelten Konturen angedeutet ist). Hiermit wird eine besonders einfache und robuste selbsthemmende Konfiguration erzielt, bei welcher das Stellelement 115.2 nach Erzeugung der Stellbewegung nicht mehr mit Energie versorgt werden muss.

Bei der nachfolgend beschriebenen Variante der Figur 5 wird für das Stellelement 115.2 ein pneumatischer Balgaktuator als Stelleinheit 115.4 des Stellelements 115.2 verwendet. Der Balgaktuator 115.4 wirkt in der Stellrichtung AD auf ein Schnittstellenelement 111.5 für die Stützfedereinrichtung 113.1 und erzeugt dabei deren Stellbewegung in der Stellrichtung AD (wie dies in Figur 5 durch die gestrichelten Konturen angedeutet ist).

Dabei ist eine Halteeinrichtung 115.5 in Form einer Klemmeinrichtung vorgesehen die dazu ausgebildet ist, das Stellelement 115.2 nach Entfernen der Ansteuerung in dem (in Figur 5 dargestellten) Haltezustand zu halten, in dem das aktive Stellelement die zweite Ausdehnung DIM2 ohne Ansteuerung beibehält. Die Halteeinrichtung 115.5 kann passiv gestaltet sein und die Klemmkraft auf das Schnittstellenelement 111.5 zu jeder Zeit ausüben (wobei der Balgaktuator 115.4 diese dann bei der Stellbewegung überwinden muss). Vorzugsweise ist die Halteeinrichtung 115.5 durch die Steuereinheit 109.2 schaltbar ausgebildet. Vorzugsweise erfolgt die Ansteuerung dabei zum zeitweisen Lösen der Klemmung während des Kriechkompensationsmodus CCM.

Bei weiteren Varianten kann für das Stellelement 115.2 ein hydraulischer Balgaktuator als Stelleinheit 115.4 des Stellelements 115.2 verwendet werden, der bei entsprechender Inkompressibilität des verwendeten Arbeitsmediums dann als Wegaktuator wirkt. Die Klemmeinrichtung 115.5 kann dann gegebenenfalls entfallen. Die Halteeinrichtung kann dann einfach durch ein entsprechendes Sperrventil in der bzw. den an den Balgaktuator angeschlossenen Leitungen für das Arbeitsmedium realisiert sein. Dabei können insbesondere einfache Rückschlagventile zum Einsatz kommen, wenn Stellbewegungen nur in einer Richtung zu erwarten bzw. erforderlich sind.

Für die jeweilige Stelleinheit 115.4 der Figuren 4 und 5 kann ein beliebiger Aktuator verwendet werden, der durch die Steuereinheit 109.2 entsprechend angesteuert wird. Dabei sowohl der oben bereits beschriebene Regelkreis verwendet werden (der das Erreichen des in Figur 2 dargestellten Zustands als Regelziel überwacht) oder aber auch eine offene Steuerstrecke. Letztere kann insbesondere bei der Verwendung eines Wegaktuators mit ausreichend genau bekanntem Stellverhalten verwendet werden. Insbesondere für die Stelleinheit 115.4 ein piezoelektrischer Schrittantrieb (so genannter "Piezokrabbler") verwendet werden.

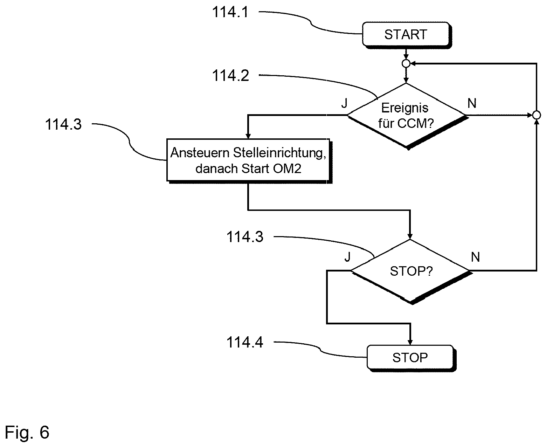

Mit den vorstehend beschriebenen Gestaltungen lässt sich das erfindungsgemäße Verfahren in der oben beschriebenen Weise ausführen. Dabei wird wie in Figur 6 gezeigt zunächst in einem Schritt 114.1 der Verfahrensablauf gestartet. Dies geschieht beispielsweise mit erstmaliger Inbetriebnahme der Abbildungseinrichtung 101, wobei sich die Abbildungseinrichtung dann in dem ersten Betriebszustand OM1 befindet.

In einem Schritt 114.2 wird dann in der Steuereinrichtung 109 überprüft, ob eines der oben beschriebenen Ereignisse eingetreten ist, welches die Aktivierung des Kriechkompensationsmodus CCM auslöst. Ist dies nicht der Fall, wird diese Überprüfung wiederholt. Ist dies jedoch der Fall, wird in der Steuereinrichtung 109 in einem Schritt 114.3 in der oben beschriebenen Weise die aktive Stelleinrichtung 115.1 angesteuert, wobei die Steuereinrichtung 109 die Abbildungseinrichtung 101 dann in den zweiten Betriebszustand OM2 versetzt (der dann an die Stelle des ersten Betriebszustands OM1 tritt). In einem Schritt 114.3 wird dann in der Steuereinrichtung 109 überprüft, ob der Verfahrensablauf beendet werden soll. Ist dies nicht der Fall, wird zum Schritt 114.2 zurück gesprungen. Andernfalls endet der Verfahrensablauf in einem Schritt 114.4. Im Übrigen wird hinsichtlich weiterer Details des Verfahrens zur Vermeidung von Wiederholungen auf die obigen Ausführungen verwiesen.

Die vorliegende Erfindung wurde vorstehend ausschließlich anhand von Beispielen beschrieben, bei denen die Lage jedes der optischen Elemente der Elementgruppe 107.1 bezüglich der zentralen Referenz 112 aktiv eingestellt wurde. Es versteht sich jedoch, dass bei anderen Varianten auch nur ein Teil (gegebenenfalls sogar nur eines) der optischen Elemente der Elementgruppe 107.1 unmittelbar bezüglich der zentralen Referenz 112 aktiv eingestellt werden kann, während die übrigen optischen Elemente der Elementgruppe 107.1 relativ zu einem dieser bezüglich der zentralen Referenz 112 aktiv eingestellten optischen Elemente aktiv eingestellt werden. Insbesondere kann nur eines der optischen Elemente der Elementgruppe 107.1 als Referenzelement dienen und unmittelbar bezüglich der zentralen Referenz 112 aktiv eingestellt werden, während alle übrigen optischen Elemente der Elementgruppe 107.1 relativ zu diesem Referenzelement (und damit also nur mittelbar bezüglich der zentralen Referenz 112) aktiv eingestellt werden.

Die vorliegende Erfindung wurde vorstehend ausschließlich anhand von Beispielen aus dem Bereich der Mikrolithographie beschrieben. Es versteht sich jedoch, dass die Erfindung auch im Zusammenhang mit beliebigen anderen optischen Anwendungen, insbesondere Abbildungsverfahren bei anderen Wellenlängen, zum Einsatz kommen kann, bei denen sich ähnliche Probleme hinsichtlich der Abstützung schwerer optischer Einheiten stellen.

Weiterhin kann die Erfindung im Zusammenhang mit der Inspektion von Objekten, wie beispielsweise der so genannten Maskeninspektion zu Einsatz kommen, bei welcher die für die Mikrolithographie verwendeten Masken auf ihre Integrität etc. untersucht werden. An Stelle des Substrats 105.1 tritt dann in Figur 1 beispielsweise eine Sensoreinheit, welche die Abbildung des Projektionsmusters der Maske 104.1 (zur weiteren Verarbeitung) erfasst. Diese Maskeninspektion kann dann sowohl im Wesentlichen bei derselben Wellenlänge erfolgen, die im späteren Mikrolithographieprozess verwendet wird. Ebenso können aber auch beliebige hiervon abweichende Wellenlängen für die Inspektion verwendet werden.

Die vorliegende Erfindung wurde vorstehend schließlich anhand konkreter Ausführungsbeispiele beschrieben, welches konkrete Kombinationen der in den nachfolgenden Patentansprüchen definierten Merkmale zeigt. Es sei an dieser Stelle ausdrücklich darauf hingewiesen, dass der Gegenstand der vorliegenden Erfindung nicht auf diese Merkmalskombinationen beschränkt ist, sondern auch sämtliche übrigen Merkmalskombinationen, wie sie sich aus den nachfolgenden Patentansprüchen ergeben, zum Gegenstand der vorliegenden Erfindung gehören.

## Patentansprüche

1. Anordnung einer optischen Abbildungseinrichtung für die Mikrolithographie, insbesondere für die Verwendung von Licht im extremen UV-Bereich (EUV), mit
- einer ersten Stützstruktur (111.1) und
- einer zweiten Stützstruktur (111.2),
wobei
- die erste Stützstruktur (111.1) dazu ausgebildet ist, wenigstens ein optisches Element (107.2) der Abbildungseinrichtung abzustützen,
- die erste Stützstruktur (111.1) die zweite Stützstruktur (111.2) über eine Mehrzahl von Stützfedereinrichtungen (113.1) einer Schwingungsentkopplungseinrichtung (113) abstützt,
- die Stützfedereinrichtungen (113.1) kinematisch parallel zueinander zwischen der ersten Stützstruktur (111.1) und der zweiten Stützstruktur (111.2) wirken,
- jede der Stützfedereinrichtungen (113.1) eine Stützkraftrichtung definiert, in der sie eine Stützkraft zwischen der ersten Stützstruktur (111.1) und der zweiten Stützstruktur (111.2) ausübt, sowie eine Stützlänge entlang der Stützkraftrichtung definiert und
- die zweite Stützstruktur (111.2) eine Messeinrichtung (109.1) abstützt, die zum Messen der Position und/oder Orientierung des wenigstens einen optischen Elements (107.2) bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Kriechkompensationseinrichtung (115) zur Kompensation einer Änderung einer statischen Relativlage zwischen der ersten Stützstruktur (111.1) und der zweiten Stützstruktur (111.2) in wenigstens einem Korrekturfreiheitsgrad vorgesehen ist,
wobei
- die Relativlageänderung insbesondere durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt,
- die Kriechkompensationseinrichtung (115) eine ansteuerbare aktive Stelleinrichtung (115.1) mit wenigstens einem aktiven Stellelement (115.2) umfasst, die dazu ausgebildet ist, eine Länge der Stützfedereinrichtung (113.1) entlang der Stützkraftrichtung der Stützfedereinrichtung (113.1) zu verändern und/oder einen Abstand der Schnittstellen (111.3; 111.4) der Stützfedereinrichtung (113.1) zu der ersten Stützstruktur (111.1) und der zweiten Stützstruktur (111.2) entlang der Stützkraftrichtung der Stützfedereinrichtung (113.1) zu verändern.

2. Anordnung nach Anspruch 1, wobei
- die aktive Stelleinrichtung (115.1) als aktives Stellelement (115.2) einen Kraftaktuator umfasst
und/oder
- die aktive Stelleinrichtung (115.1) als aktives Stellelement (115.2) einen Wegaktuator umfasst
und/oder
- die aktive Stelleinrichtung (115.1) als aktives Stellelement (115.2) ein piezoelektrisches Stellelement umfasst.
und/oder
- die aktive Stelleinrichtung (115.1) als aktives Stellelement (115.2) einen Lorentz-Aktuator umfasst.
und/oder
- die aktive Stelleinrichtung (115.1) als aktives Stellelement (115.2) einen hydraulischen Aktuator, insbesondere einen hydraulischen Balgaktuator, umfasst
und/oder
- die aktive Stelleinrichtung (115.1) als aktives Stellelement (115.2) einen pneumatischen Aktuator, insbesondere einen pneumatischen Balgaktuator, umfasst.

3. Anordnung nach Anspruch 1 oder 2, wobei
- die aktive Stelleinrichtung (115.1) als aktives Stellelement (115.2) ein aktives piezoelektrisches Stellelement umfasst und
- das wenigstens eine piezoelektrische Stellelement (115.2) bei Anlegen einer elektrischen Spannung eine Stellbewegung in einer Stellrichtung durch eine ferroelektrische Domänenumschaltung erzeugt.

4. Anordnung nach Anspruch 3, wobei
- das wenigstens eine piezoelektrische Stellelement (115.2) vor dem Anlegen der elektrischen Spannung in der Stellrichtung eine erste Ausdehnung aufweist,
- das wenigstens eine piezoelektrische Stellelement (115.2) bei Anlegen der elektrischen Spannung in einen Stellzustand mit einer zweiten Ausdehnung in der Stellrichtung verbracht wird, wobei die erste Ausdehnung von der zweiten Ausdehnung verschieden ist, und
- sich das wenigstens eine piezoelektrische Stellelement (115.2) nach Entfernen der elektrischen Spannung in einem Haltezustand befindet, in dem es die zweite Ausdehnung spannungslos beibehält.

5. Anordnung nach einem der Ansprüche 1 bis 4, wobei
- das wenigstens eine aktive Stellelement (115.2) vor dem Ansteuern der aktiven Stelleinrichtung (115.1) in der Stellrichtung eine erste Ausdehnung aufweist,
- das wenigstens eine Stellelement (115.2) durch das Ansteuern der aktiven Stelleinrichtung (115.1) in einen Stellzustand mit einer zweiten Ausdehnung in der Stellrichtung verbracht wird, wobei die erste Ausdehnung von der zweiten Ausdehnung verschieden ist,
- eine Halteeinrichtung (115.3; 115.5), insbesondere eine Klemmeinrichtung, vorgesehen ist, die insbesondere schaltbar ausgebildet ist, und
- die Halteeinrichtung (115.3; 115.5) dazu ausgebildet ist, das wenigstens eine aktive Stellelement (115.2) nach Entfernen der Ansteuerung der aktiven Stelleinrichtung (115.1) in einem Haltezustand zu halten, in dem das aktive Stellelement (115.2) die zweite Ausdehnung ohne Ansteuerung beibehält.

6. Anordnung nach Anspruch 5, wobei
- die Halteeinrichtung (115.3; 115.5) in der Stellrichtung selbsthemmend ausgebildet ist,
wobei insbesondere
- die Halteeinrichtung (115.3) wenigstens zwei Keilelemente (115.3) umfasst, die derart angeordnet und ausgebildet sind, dass die zwei Keilelemente (115.3) bei der Ansteuerung der aktiven Stelleinrichtung (115.1) durch wenigstens eine Stelleinheit (115.4) des wenigstens einen aktiven Stellelements (115.2) gegeneinander in einer Verschieberichtung quer zu der Stellrichtung verschoben werden, wobei
- die zwei Keilelemente (115.3) insbesondere bei der Verschiebung aufeinander gleiten und dabei eine Stellbewegung in der Stellrichtung erzeugen.

7. Anordnung nach einem der Ansprüche 1 bis 6, wobei
- das wenigstens eine aktive Stellelement (115.2) eine Komponente der wenigstens einen Stützfedereinrichtung (113.1) ist,
wobei
- das wenigstens eine aktive Stellelement (115.2) insbesondere Teil einer Kopplungseinheit (113.2) zweier mechanischer Federeinheiten der wenigstens einen Stützfedereinrichtung (113.1) ist.

8. Anordnung nach einem der Ansprüche 1 bis 7, wobei
- das wenigstens eine aktive Stellelement (115.2) dazu ausgebildet ist, eine erste Schnittstelleneinheit (111.3) der ersten Stützstruktur (111.1) für die wenigstens eine Stützfedereinrichtung (113.1) entlang der Stützkraftrichtung zu verstellen,
und/oder
- das wenigstens eine aktive Stellelement (115.2) dazu ausgebildet ist, eine zweite Schnittstelleneinheit (111.4) der zweiten Stützstruktur (111.2) für die wenigstens eine Stützfedereinrichtung (113.1) entlang der Stützkraftrichtung zu verstellen.

9. Anordnung nach einem der Ansprüche 1 bis 8, wobei
- eine Steuereinrichtung (109) vorgesehen ist und
- die Steuereinrichtung (109) dazu ausgebildet ist, in Abhängigkeit von der Längenänderung der wenigstens einen Stützfedereinrichtung (113.1) entlang ihrer Stützkraftrichtung die aktive Stelleinrichtung (115.1) anzusteuern,
wobei insbesondere
- die Steuereinrichtung (109) zur Ermittlung der Längenänderung der wenigstens einen Stützfedereinrichtung (113.1) entlang ihrer Stützkraftrichtung ein das Kriechverhalten der Stützfedereinrichtung (113.1) beschreibendes Kriechmodell der Stützfedereinrichtung (113.1) verwendet.

10. Anordnung nach einem der Ansprüche 1 bis 9, wobei
- eine Erfassungseinrichtung (109.4) und eine Steuereinrichtung (109) vorgesehen ist,
- die Erfassungseinrichtung (109.4) dazu ausgebildet ist, wenigstens einen für die Relativlage zwischen der ersten Stützstruktur (111.1) und der zweiten Stützstruktur (111.2) repräsentativen Relativlageerfassungswert zu erfassen und an die Steuereinrichtung (109) auszugeben, und
- die Steuereinrichtung (109) dazu ausgebildet ist, in Abhängigkeit von dem Relativlageerfassungswert, insbesondere in Abhängigkeit von einer zeitlichen Änderung des Relativlageerfassungswerts, die aktive Stelleinrichtung (115.1) anzusteuern.

11. Anordnung nach Anspruch 10, wobei
- die Steuereinrichtung (109) dazu ausgebildet ist, die aktive Stelleinrichtung (115.1) erst anzusteuern, wenn eine Abweichung des Relativlageerfassungswerts von einem vorgebbaren Relativlagesollwert einen vorgebbaren Grenzwert überschreitet,
wobei insbesondere
- der Korrekturfreiheitsgrad ein Rotationsfreiheitsgrad ist, insbesondere ein Rotationsfreiheitsgrad um eine quer zu der Gravitationsrichtung verlaufende Kippachse ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µrad bis 1000 µrad, vorzugsweise 1 µrad bis 200 µrad, weiter 10 µrad bis 100 µrad, repräsentativ ist
und/oder
- der Korrekturfreiheitsgrad ein Translationsfreiheitsgrad ist, insbesondere ein Translationsfreiheitsgrad entlang der Gravitationsrichtung ist, und der vorgebbare Grenzwert für eine Abweichung der Relativlage zwischen der ersten Stützstruktur (111.1) und der zweiten Stützstruktur (111.2) von einer vorgebbaren Relativsolllage um 0,1 µm bis 1000 µm, vorzugsweise 1 µm bis 200 µm, weiter 10 µm bis 100 µm, repräsentativ ist.

12. Anordnung nach einem der Ansprüche 1 bis 11, wobei
- der wenigstens eine Korrekturfreiheitsgrad ein Rotationsfreiheitsgrad um eine quer zu der Gravitationsrichtung verlaufende Kippachse ist
und/oder
- der wenigstens eine Korrekturfreiheitsgrad ein Translationsfreiheitsgrad entlang der Gravitationsrichtung ist.

13. Optische Abbildungseinrichtung, insbesondere für die Mikrolithographie, mit
- einer Beleuchtungseinrichtung (102) mit einer ersten optischen Elementgruppe (106),
- einer Objekteinrichtung (104) zur Aufnahme eines Objekts (104.1),
- einer Projektionseinrichtung (103) mit einer zweiten optischen Elementgruppe (107) und
- einer Bildeinrichtung (105), wobei
- die Beleuchtungseinrichtung (102) zur Beleuchtung des Objekts (104.1) ausgebildet ist und
- die Projektionseinrichtung (103) zur Projektion einer Abbildung des Objekts (103.1) auf die Bildeinrichtung (105) ausgebildet ist,
**dadurch gekennzeichnet, dass**
- die Beleuchtungseinrichtung (102) und/oder die Projektionseinrichtung (103) wenigstens eine Anordnung (108) nach einem der Ansprüche 1 bis 12 umfasst.

14. Verfahren für eine optische Abbildungseinrichtung für die Mikrolithographie, insbesondere für die Verwendung von Licht im extremen UV-Bereich (EUV), bei dem
- eine erste Stützstruktur (111.1) eine zweite Stützstruktur (111.2) über eine Mehrzahl von Stützfedereinrichtungen (113.1) einer Schwingungsentkopplungseinrichtung (113) abstützt und dazu ausgebildet ist, wenigstens ein optisches Element (107.2) der Abbildungseinrichtung abzustützen,
- die Stützfedereinrichtungen (113.1) kinematisch parallel zueinander zwischen der ersten Stützstruktur (111.1) und der zweiten Stützstruktur (111.2) wirken,
- jede der Stützfedereinrichtungen (113.1) eine Stützkraftrichtung definiert, in der sie eine Stützkraft zwischen der ersten Stützstruktur (111.1) und der zweiten Stützstruktur (111.2) ausübt, sowie eine Stützlänge entlang der Stützkraftrichtung definiert und
- die zweite Stützstruktur (111.2) eine Messeinrichtung (109.1) abstützt, die zum Messen der Position und/oder Orientierung des wenigstens einen optischen Elements (107.2) bezüglich einer Referenz (112), insbesondere einer Referenz (112) der zweiten Stützstruktur (111.2), in wenigstens einem Freiheitsgrad bis hin zu allen sechs Freiheitsgraden im Raum ausgebildet ist,
**dadurch gekennzeichnet, dass**
- eine Änderung einer statischen Relativlage zwischen der ersten Stützstruktur (111.1) und der zweiten Stützstruktur (111.2) in wenigstens einem Freiheitsgrad in einem Kompensationsschritt kompensiert wird,
wobei
- die Relativlageänderung durch eine Längenänderung wenigstens einer der Stützfedereinrichtungen (113.1) entlang ihrer Stützkraftrichtung bedingt ist, die sich aus einem Kriechprozess der Stützfedereinrichtung (113.1) ergibt, und
- eine Länge der Stützfedereinrichtung (113.1) entlang der Stützkraftrichtung der Stützfedereinrichtung (113.1) durch ein aktives Stellelement (115.2) einer aktiven Stelleinrichtung (115.1) verändert wird und/oder eine Abstand der Schnittstellen der Stützfedereinrichtung (113.1) zu der ersten Stützstruktur (111.1) und der zweiten Stützstruktur (111.2) entlang der Stützkraftrichtung der Stützfedereinrichtung (113.1) durch ein aktives Stellelement (115.2) einer aktiven Stelleinrichtung (115.1) verändert wird.

15. Verfahren nach Anspruch 14, wobei
- in dem Kompensationsschritt wenigstens ein piezoelektrisches Stellelement (115.2) der aktiven Stelleinrichtung (115.1) angesteuert wird wobei insbesondere
- an das wenigstens eine piezoelektrische Stellelement (115.2) eine elektrische Spannung angelegt wird und
- das wenigstens eine piezoelektrische Stellelement (115.2) bei Anlegen der elektrischen Spannung eine Stellbewegung in einer Stellrichtung durch eine ferroelektrische Domänenumschaltung erzeugt.

16. Verfahren nach Anspruch 15, wobei
- das wenigstens eine piezoelektrische Stellelement (115.2) vor dem Anlegen der elektrischen Spannung in der Stellrichtung eine erste Ausdehnung aufweist,
- das wenigstens eine piezoelektrische Stellelement (115.2) bei Anlegen der elektrischen Spannung in einen Stellzustand mit einer zweiten Ausdehnung in der Stellrichtung verbracht wird, wobei die erste Ausdehnung von der zweiten Ausdehnung verschieden ist,
- die elektrischen Spannung entfernt wird und
- sich das wenigstens eine piezoelektrische Stellelement (115.2) nach Entfernen der elektrischen Spannung in einem Haltezustand befindet, in dem es die zweite Ausdehnung spannungslos beibehält.

17. Verfahren nach einem der Ansprüche 14 bis 16, wobei
- das wenigstens eine aktive Stellelement (115.2) vor dem Ansteuern der aktiven Stelleinrichtung (115.1) in der Stellrichtung eine erste Ausdehnung aufweist,
- das wenigstens eine Stellelement (115.2) in dem Kompensationsschritt durch das Ansteuern der aktiven Stelleinrichtung (115.1) in einen Stellzustand mit einer zweiten Ausdehnung in der Stellrichtung verbracht wird, wobei die erste Ausdehnung von der zweiten Ausdehnung verschieden ist, und
- das wenigstens eine aktive Stellelement (115.2) nach Entfernen der Ansteuerung der aktiven Stelleinrichtung (115.1) in einem Haltezustand gehalten wird, insbesondere geklemmt wird, in dem das aktive Stellelement (115.2) die zweite Ausdehnung ohne Ansteuerung beibehält.
